# EUROPÄISCHE PATENTSCHRIFT

(11) **EP 2 119 330 B1**
(45) Veröffentlichungstag und Bekanntmachung des Hinweises auf die Patenterteilung: **19.07.2017**
(21) Anmeldenummer: 08700296.0
(22) Anmeldetag: 30.01.2008
(51) Int. Cl.: H05K 3/46, H05K 1/02

(54) **VERFAHREN ZUM HERSTELLEN EINER STARR-FLEXIBLEN LEITERPLATTE**
METHOD FOR PRODUCING A FLEXI-RIGID PRINTED CIRCUIT BOARD
PROCÉDÉ DE FABRICATION D'UNE CARTE DE CIRCUITS IMPRIMÉS FLEXO-RIGIDE

(30) Priorität: 16.02.2007 AT 9907 U
(43) Veröffentlichungstag der Anmeldung: 18.11.2009
(73) Patentinhaber: AT & S Austria Technologie & Systemtechnik Aktiengesellschaft, 8700 Leoben-Hinterberg (AT)
(72) Erfinder: STAHR, Johannes, A-8600 Bruck (AT); LEITGEB, Markus, A-8793 Trofaiach (AT)
(74) Vertreter: Miksovsky, Alexander
(86) Internationale Anmeldenummer: PCT/AT2008/000030
(87) Internationale Veröffentlichungsnummer: WO 2008/098272

(56) Entgegenhaltungen:
- DE-C1- 4 003 344
- DE-U1- 20 221 121
- DE-U1- 20 221 189
- JP-A- H1 022 645

## Beschreibung

Die vorliegende Erfindung bezieht sich auf ein Verfahren zum Herstellen einer starr-flexiblen Leiterplatte, nach Anspruch 1 wobei wenigstens ein starrer Bereich einer Leiterplatte über eine Schicht aus nicht-leitendem Material bzw. eine Dielektrikumschicht mit wenigstens einem flexiblen Bereich der Leiterplatte verbunden wird, wobei nach einem Verbinden des wenigstens einen starren und flexiblen Bereichs der Leiterplatte der starre Bereich der Leiterplatte durchtrennt wird und eine Verbindung zwischen den voneinander getrennten, starren Teilbereichen der Leiterplatte über den damit verbundenen, flexiblen Bereich hergestellt wird, wobei die Verbindung zwischen dem wenigstens einen starren Bereich der Leiterplatte und dem wenigstens einen flexiblen Bereich der Leiterplatte vor einem Durchtrennen des starren Bereichs über eine Verklebung vorgenommen wird, wobei im Bereich der nachfolgenden Durchtrennung des starren Bereichs der Leiterplatte eine Kleberschicht aufgebracht wird, welche einer vollständigen Härtung unterworfen wird.

Die in den letzten Jahren an Komplexität zunehmende Konstruktion elektronischer Bauteile führt allgemein zu einem Erhöhen der Anzahl von Verbindungs- bzw. Anbindungspunkten von aktiven Bauteilen zu Bestandteilen einer Leiterplatte, wobei mit einer zunehmenden Reduktion der Größe gleichzeitig eine Reduktion des Abstands zwischen derartigen Anbindungspunkten vorzusehen ist. Im Zusammenhang mit der Herstellung von Leiterplatten wurde hierbei eine Entflechtung von derartigen Verbindungs- bzw. Anbindungspunkten von Bauteilen über Mikrovias über mehrere Leiterplattenlagen hinweg in sogenannten High Density Interconnects (HDI) vorgeschlagen.

Neben einer zunehmenden Erhöhung der Komplexität des Designs bzw. der Konstruktion von Leiterplatten und einer damit einhergehenden Miniaturisierung sind zusätzliche Anforderungen im Hinblick auf falz- bzw. biegefähige Verbindungen in einer Leiterplatte entstanden, welche zur Entwicklung einer Hybridtechnik und zum Einsatz sogenannter starr-flexibler Leiterplatten führte. Derartige starr-flexible Leiterplatten, welche aus starren Bereichen bzw. Teilbereichen der Leiterplatte sowie derartige starre Bereiche verbindenden, flexiblen Bereichen bestehen, erhöhen die Zuverlässigkeit, bieten weitere bzw. zusätzliche Möglichkeiten einer Freiheit des Designs bzw. der Konstruktion und ermöglichen weitere Miniaturisierungen.

Zur Herstellung derartiger starr-flexibler Leiterplatten sind zwischen starren und flexiblen Bereichen einer Leiterplatte diesen entsprechende Verbindungsschichten aus einem dielektrischen Material vorzusehen, wobei eine Anordnung von entsprechenden blattförmigen Schichten bzw. Folien, welche beispielsweise durch eine Wärmebehandlung zu einer Verbindung von miteinander zu verbindenden, starren und flexiblen Bereichen einer Leiterplatte führen, üblicherweise vergleichsweise dicke Schichten ergeben. Derartige dicke Schichten wirken nicht nur einer beabsichtigten Miniaturisierung bei der Herstellung von mehrlagigen Leiterplatten entgegen, sondern führen auch zu einem Verlust an Registriergenauigkeit für nachfolgende Laser-Bohrlochgeometrien zur Ausbildung der Mikrovias und entsprechend eng beabstandeter Verbindungs- bzw. Anbindungsstellen. Derartige dicke, bekannte Schichten aus nicht-leitendem Material bzw. Dielektrikumschichten führen darüber hinaus zu zusätzlichen Verarbeitungs- bzw. Prozeßschritten und/oder zu einem aufwendigeren Design zur Herstellung der erforderlichen Verbindungen zwischen den starren und flexiblen Bereichen der Leiterplatten.

Aus der DE 202 21 121 U1 und der DE 202 21 189 U1 sind jeweils eine Leiterplatte ähnlich der eingangs genannten Art mit mindestens einem starren Bereich und einem flexiblen Bereich zu entnehmen, wobei eine Verklebung zwischen Lagen des starren und flexiblen Bereichs erfolgt, wobei jeweils auf eine einfache und kostengünstige Herstellung abgezielt wird.

Aus der JP 10-022645 A ist im Zusammenhang mit einer Herstellung einer Leiterplatte mit einem Hohlraum die Verwendung von zwei Kleberschichten bekannt geworden.

Die vorliegende Erfindung zielt darauf ab, ein Verfahren der eingangs genannten Art dahingehend weiterzubilden, dass starr-flexible Leiterplatten für hochkomplexe, elektronische Bauteile in einem vereinfachten Verfahren hergestellt werden können, wobei darüber hinaus darauf abgezielt wird, gegenüber bekannten Ausführungsformen Schichten aus nicht-leitendem Material bzw. Dielektrikumschichten zwischen einzelnen, starren und flexiblen Bereichen der Leiterplatte dünner auszubilden. Weiters wird darauf abgezielt, die Be- bzw. Verarbeitung in weiteren Schritten beispielsweise durch eine erhöhte Registriergenauigkeit zu verbessern.

Zur Lösung dieser Aufgaben ist ein Verfahren der eingangs genannten Art im wesentlichen dadurch gekennzeichnet, dass angrenzend an die partiell aufgebrachte und vollständig gehärtete Kleberschicht eine weitere Kleberschicht auf dem starren Bereich der Leiterplatte aufgebracht wird, welche in weiterer Folge lediglich teilweise gehärtet wird, und dass nach dem teilweisen Härten der zweiten bzw. angrenzenden Kleberschicht der starre Bereich der Leiterplatte mit dem flexiblen Bereich der Leiterplatte unter Zwischenschaltung der Kleberschicht durch ein anschließendes, vollständiges Härten der zweiten Kleberschicht verbunden wird und dass an der Stelle des nach Aufbringung des flexiblen Bereichs der Leiterplatte zu durchtrennenden, starren Bereichs der Leiterplatte und nach Aufbringen einer Kleberschicht in an sich bekannter Weise Fräskanten über einen Teilbereich der Dicke des starren Bereichs der Leiterplatte ausgebildet werden. Da anstelle der bisher bekannten, blattartigen Folien, welche zur Verbindung von starren und flexiblen Bereichen einer Leiterplatte Verwendung finden, die Verbindung derartiger starrer und flexibler Bereiche der Leiterplatte über eine Verklebung vorgenommen wird, fallen die Beschränkungen hinsichtlich der erforderlichen Registriergenauigkeit der zwischen den starren und flexiblen Bereichen der Leiterplatte vorzusehenden Schicht aus nicht-leitendem Material bzw. der Dielektrikumschicht insbesondere für eine weitergehende Be- bzw. Verarbeitung weg, da der die Verklebung ausbildende Kleber mit einfachen Verfahrensschritten und entsprechend hoher Genauigkeit unmittelbar auf den starren Bereich der Leiterplatte aufgebracht werden kann, worauf in einfacher Weise durch Festlegen der flexiblen Leiterplattenschicht auf dem mit dem Kleber versehenen, starren Bereich der Leiterplatte eine zuverlässige Verbindung herstellbar ist. Darüber hinaus gelingt es durch die erfindungsgemäß vorgeschlagene Verwendung eines Klebers zur Herstellung einer Verbindung zwischen wenigstens einem starren und wenigstens einem flexiblen Bereich der Leiterplatte, mit dünneren Schichtstärken für das nicht-leitende Material bzw. die Dielektrikumschicht das Auslangen zu finden, so dass im Sinn einer weiteren Miniaturisierung und Verringerung der Gesamtdicke der erfindungsgemäß herzustellenden, starr-flexiblen Leiterplatte weitere Vorteile erzielbar sind. Dadurch, dass erfindungsgemäß die im Bereich der nachfolgenden Durchtrennung in einem ersten Verfahrensschritt aufgebrachte Kleberschicht vollständig gehärtet wird, wird nachfolgend eine Verbindung mit dem damit zu verbindenden, flexiblen Bereich der Leiterplatte vermieden, so dass im nachfolgenden Durchtrennungsschritt des starren Bereichs der Leiterplatte ohne übermäßig genaue Einstellung der Tiefe eines Durchtrennens die lediglich mit dem zu entfernenden Bereich des starren Bereichs der Leiterplatte verbundene, in einem ersten Verfahrensschritt aufgebrachte und vollständig gehärtete Kleberschicht unmittelbar entfernt wird. Es muss somit für die nachfolgende Durchtrennung lediglich dafür Sorge getragen werden, dass das Trennwerkzeug zuverlässig vollständig den starren Bereich der Leiterplatte durchtrennt, wobei eine entsprechend genaue Einstellung der Schnitt- bzw. Durchtrennungstiefe abgestimmt auf die Dicke der Kleberschicht darüber hinaus nicht zwingend erforderlich ist. Eine zuverlässige Verbindung der nach einem Durchtrennen verbleibenden, starren Bereiche der Leiterplatte mit dem damit zu verbindenden, flexiblen Bereich der Leiterplatte erfolgt über die in einem zweiten Aufbringungsschritt der Kleberschicht aufzubringende, zweite Kleberschicht, welche einleitend lediglich teilweise gehärtet wird, so dass nach dem Festlegen des flexiblen Bereichs der Leiterplatte in einem nachfolgenden Härtungsschritt eine zuverlässige Verbindung zwischen dem starren Bereich der Leiterplatte und dem flexiblen Bereich der Leiterplatte vor dem darauffolgenden Durchtrennungsschritt erzielbar ist. Darüber hinaus verhindert der im ersten Aufbringungsschritt des Klebers im Bereich der nachfolgenden Durchtrennung aufgebrachte und vollständig gehärtete Kleber ein Fließen der nachfolgend aufgebrachten, zweiten und an die erste Kleberschicht angrenzenden Kleberschicht insbesondere während des vollständigen Verbindens zwischen dem starren Bereich der Leiterplatte und dem flexiblen Bereich der Leiterplatte.

Zur Erzielung einer ordnungsgemäßen und genau definierten Durchtrennung des starren Bereichs der Leiterplatte insbesondere im Bereich der Verbindung mit dem daran festzulegenden, flexiblen Bereich der Leiterplatte ist es bekannt, vor der Verbindung mit dem flexiblen Bereich der Leiterplatte Fräskanten an der Stelle der nachfolgend durchzuführenden Durchtrennung auszubilden. Durch die erfindungsgemäß vorgesehene Verbindung über einen Kleber lässt sich die Genauigkeit der Positionierung weiter dahingehend verbessern, dass an der Stelle des nach Aufbringung des flexiblen Bereichs der Leiterplatte zu durchtrennenden, starren Bereichs der Leiterplatte und nach Aufbringen einer Kleberschicht in an sich bekannter Weise Fräskanten über einen Teilbereich der Dicke des starren Bereichs der Leiterplatte ausgebildet werden.

Es gelingt derart in weiterer Folge ohne übermäßig genaue Einstellung der Schnittiefe des zu durchtrennenden, starren Bereichs der Leiterplatte eine ordnungsgemäße Trennung, wobei in diesem Zusammenhang gemäß einer bevorzugten Ausführungsform vorgeschlagen wird, dass nach einem Festlegen des flexiblen Bereichs der Leiterplatte an dem starren Bereich der Leiterplatte ausgehend von der von der Ausbildung der Fräskanten abgewandten Oberfläche des starren Bereichs der Leiterplatte eine Durchtrennung des starren Bereichs der Leiterplatte bis in den Bereich der zwischen den Fräskanten vorliegenden Kleberschicht vorgenommen wird.

Für eine besonders einfache und zuverlässige Aufbringung des Klebers zur Herstellung der Verklebung zwischen dem wenigstens einen starren und dem wenigstens einen flexiblen Teilbereich der erfindungsgemäß herzustellenden, starr-flexiblen Leiterplatte wird gemäß einer bevorzugten Ausführungsform vorgeschlagen, dass die Verklebung zwischen dem starren und flexiblen Bereich der Leiterplatte über einen druckfähigen Kleber vorgenommen wird. Ein derartiger druckfähiger Kleber lässt sich entsprechend genau und mit einer gewünschten, geringen Schichtstärke auf dem in weiterer Folge mit einem flexiblen Bereich der Leiterplatte zu verbindenden, starren Bereich auftragen.

Wie bereits oben erwähnt, gelingt es durch die erfindungsgemäß vorgesehene Verklebung zwischen dem wenigstens einen starren Teilbereich der Leiterplatte und dem flexiblen Teilbereich, mit entsprechend verringerten Schichtstärken das Auslangen zu finden, wobei in diesem Zusammenhang gemäß einer weiters bevorzugten Ausführungsform vorgeschlagen wird, dass die Schichtdicke der Verklebung mit weniger als 50 µm, insbesondere weniger als 40 µm, gewählt wird.

Zur Ermöglichung einer zuverlässigen und wenige Arbeitsschritte erfordernden Bearbeitung bei der Herstellung der Verbindung zwischen dem starren Bereich der Leiterplatte und dem flexiblen Bereich derselben wird gemäß einer weiters bevorzugten Ausführungsform der Erfindung vorgeschlagen, dass ein Ein- oder Mehrkomponentenkleber verwendet wird, welcher thermisch vernetzend härtbar ist. In diesem Zusammenhang hat sich auch unter Berücksichtigung nachfolgender Bearbeitungsschritte als besonders bevorzugt erwiesen, dass der Kleber basierend auf Epoxiden, Polyimiden, Phenolharzen oder Mischungen hievon, gegebenenfalls in Kombination mit Härtersystemen auf Basis von hydroxyl-, thiol- oder aminofunktionellen Vernetzungsgruppen gewählt wird.

Zur Erzielung einer gewünschten Be- bzw. Verarbeitbarkeit des zur Ausbildung der erfindungsgemäßen Verklebung zwischen dem starren Bereich der Leiterplatte und dem flexiblen Bereich derselben herangezogenen bzw. eingesetzten Klebers als auch zur Berücksichtigung von nachfolgenden Bearbeitungsschritten wird darüber hinaus vorgeschlagen, dass der Kleber mit anorganischen und/oder organischen Füllstoffen versehen wird, wie dies einer weiters bevorzugten Ausführungsform des erfindungsgemäßen Verfahrens entspricht.

Wie oben bereits erwähnt, gelingt ein einfaches und zuverlässiges sowie genaues Durchführen der Verklebung unter Einsatz eines druckfähigen Klebers, wobei in diesem Zusammenhang gemäß einer weiters bevorzugten Ausführungsform vorgeschlagen wird, dass der Kleber durch Siebdruck, Schablonendruck, Streichbeschichten, Walzenbeschichten oder Spinbeschichten aufgebracht wird. Derartige Druckverfahren sind für sich gesehen bekannt und können insbesondere unter Berücksichtigung der Materialeigenschaften des einzusetzenden Klebers zur Ausbildung der erfindungsgemäßen Verklebung als auch der zu erzielenden Schichtstärken und/oder Formgebung der Verbindungsschicht aus einem nicht-leitenden Material bzw. Dielektrikum zwischen dem starren Bereich der Leiterplatte und dem flexiblen Bereich der Leiterplatte entsprechend gewählt werden.

Nach einem Verbinden des wenigstens einen starren Teilbereichs der Leiterplatte mit dem flexiblen Bereich der Leiterplatte erfolgt zur Ausbildung einer Falz- bzw. Biegestelle der herzustellenden, starr-flexiblen Leiterplatte mit bekannten Verfahrensschritten eine Durchtrennung des starren Bereichs der Leiterplatte zur Ausbildung von getrennten, starren, nebeneinander liegenden Teilbereichen, welche in weiterer Folge über den damit verbundenen, flexiblen Bereich der fertiggestellten, starr-flexiblen Leiterplatte verbunden sind und an der Stelle der Durchtrennung eine entsprechend den Konstruktionsanforderungen gewünschte Biegbarkeit bereitstellen. Bei Einsatz von bisher bekannten, blattförmigen Schichten bzw. Folien zwischen dem starren Teilbereich und dem flexiblen Teilbereich ergaben sich nicht nur Probleme im Hinblick auf eine erhöhte Schichtstärke sowie auf die zu erzielende Registriergenauigkeit, sondern es musste im nachfolgenden Bearbeitungsschritt bei einem Durchtrennen des starren Bereichs der Leiterplatte auch für ein ordnungsgemäßes Durchtrennen der Zwischenschicht ohne Beschädigung bzw. Beeinträchtigung insbesondere des darunterliegenden, flexiblen Bereichs der Leiterplatte gesorgt werden.

Zur Vereinfachung des nachfolgenden Schritts eines Durchtrennens des starren Bereichs der Leiterplatte zur Ausbildung einer Biegestelle über den damit zu verbindenden, flexiblen Bereich der Leiterplatte wird gemäß einer weiters bevorzugten Ausführungsform des erfindungsgemäßen Verfahrens vorgeschlagen, dass der Kleber selektiv im Bereich der nachfolgenden Durchtrennung des starren Bereichs der Leiterplatte zur Ausbildung der getrennten, starren Teilbereiche aufgebracht wird. Durch ein derartiges selektives Aufbringen im Bereich der nachfolgenden Durchtrennung kann den Anforderungen für eine vereinfachte Verfahrensführung des nachfolgenden Trennvorgangs Rechnung getragen werden.

Für eine zuverlässige Vorhärtung bzw. Vorvernetzung der zweiten Kleberschicht vor der Festlegung des flexiblen Bereichs der Leiterplatte und ein nachfolgendes, vollständiges Härten für eine endgültige Verbindung mit dem starren Bereich der Leiterplatte wird gemäß einer bevorzugten Ausführungsform vorgeschlagen, dass die Vorhärtung bzw. Vorvernetzung der zweiten Kleberschicht bei Temperaturen unter 180 °C, insbesondere zwischen etwa 60 °C und 160 °C, vorgenommen wird.

Wie oben bereits erwähnt, finden aufgrund der zunehmenden Komplexität elektronischer Bauteile bzw. Schaltungen zunehmend mehrlagige Leiterplatten Verwendung, wobei erfindungsgemäß darüber hinaus bevorzugt vorgeschlagen wird, dass wenigstens für den starren Bereich der Leiterplatte eine mehrlagige Leiterplatte verwendet wird.

Eine starr-flexible Leiterplatte kann derart ausgebildet sein, dass im Bereich der nachfolgenden Durchtrennung des starren Bereichs der Leiterplatte vor Festlegung des flexiblen Bereichs der Leiterplatte eine vollständig gehärtete Kleberschicht vorgesehen ist, an welche eine teilweise gehärtete, zweite Kleberschicht anschließt, welche mit dem an dem starren Bereich der Leiterplatte festlegbaren, flexiblen Bereich der Leiterplatte verbindbar ist. Wie oben bereits ausgeführt, lässt sich durch Vorsehen einer Kleberschicht zur Verbindung zwischen wenigstens einem starren Bereich der Leiterplatte und einem flexiblen Bereich der Leiterplatte mit geringerer Schichtstärke zur Verbindung das Auslangen finden, wobei darüber hinaus durch Vorsehen einer Verklebung auch eine Registriergenauigkeit erzielbar ist und in weiterer Folge mit vereinfachten Verfahrensschritten, beispielsweise zur Ausbildung der Durchtrennung des starren Bereichs der Leiterplatte zur Ausbildung einer Biegestelle unter Vermittlung des flexiblen Bereichs der Leiterplatte als auch zur Bereitstellung von entsprechenden Verbindungen zwischen einzelnen, leitenden Lagen der Leiterplatte, gegebenenfalls auch zwischen dem flexiblen und dem starren Bereich derselben das Auslangen gefunden werden kann.

Die Erfindung wird nachfolgend anhand eines in der beiliegenden Zeichnung schematisch dargestellten Ausführungsbeispiels eines erfindungsgemäßen Verfahrens zur Herstellung einer starr-flexiblen Leiterplatte näher erläutert. In dieser zeigen:
Fig. 1 einen schematischen Schnitt durch eine Ausführungsform eines starren Teils einer erfindungsgemäß herzustellenden, starr-flexiblen Leiterplatte;
Fig. 2 einen schematischen Schnitt durch eine Ausführungsform eines flexiblen Bereichs einer erfindungsgemäß herzustellenden, starr-flexiblen Leiterplatte;

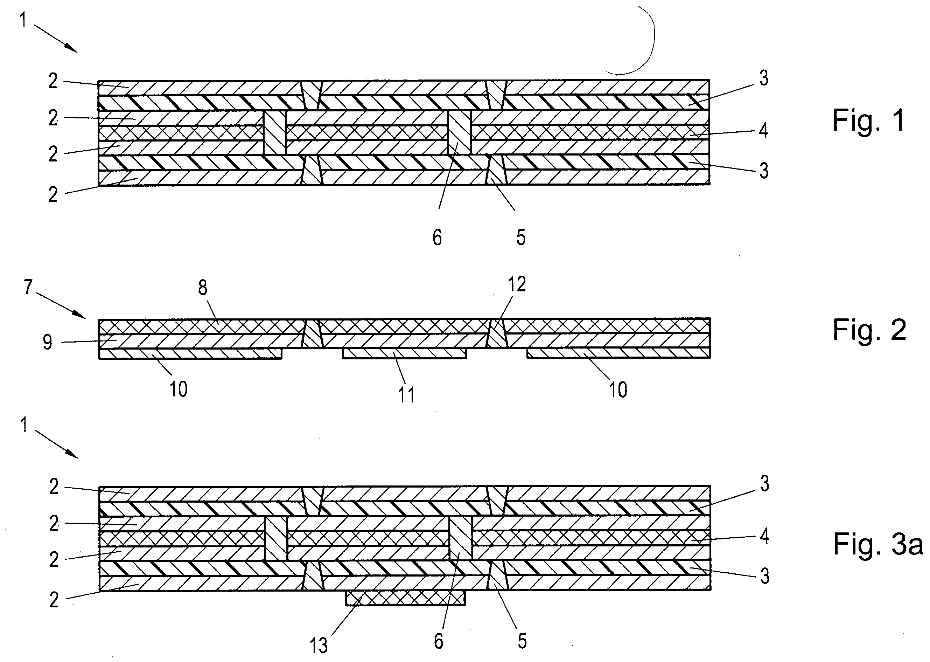

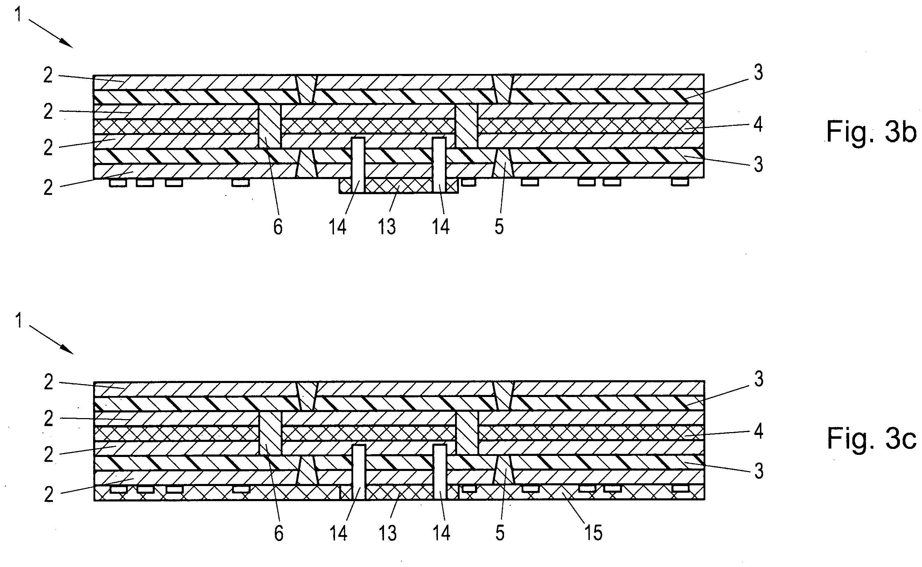

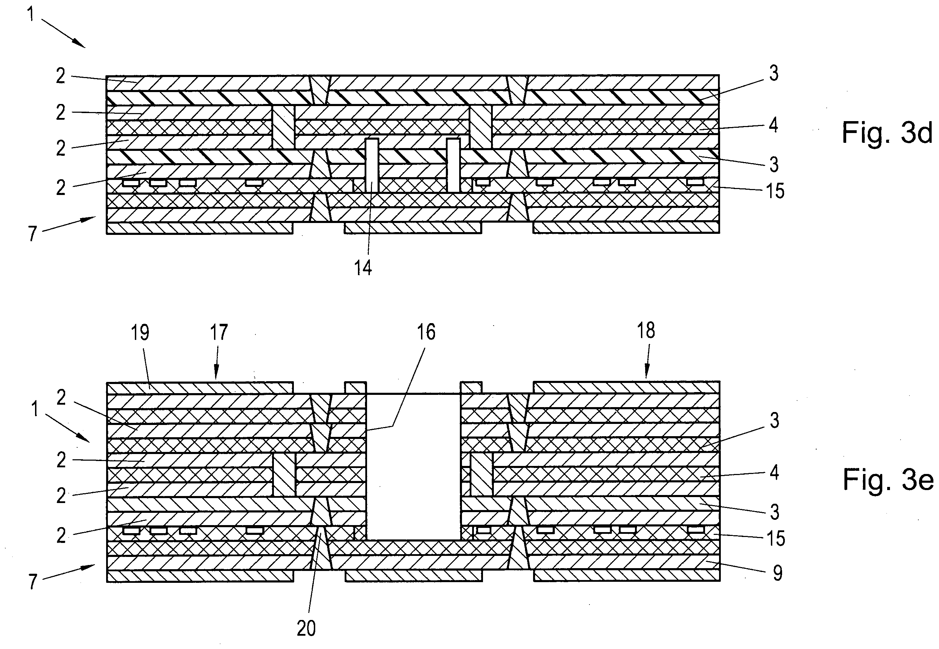

Fig. 3 einzelne Verfahrensschritte des erfindungsgemäßen Verfahrens zur Herstellung einer starr-flexiblen Leiterplatte, wobei in Fig. 3a eine Aufbringung einer Kleberschicht im Bereich einer nachfolgenden Durchtrennung des starren Bereichs der Leiterplatte angedeutet ist; in Fig. 3b die Ausbildung von Fräskanten im Bereich der nachfolgenden Durchtrennung des starren Bereichs gezeigt ist; in Fig. 3c die Aufbringung einer zweiten Kleberschicht angrenzend an die erste Kleberschicht im Bereich der nachfolgenden Durchtrennung des starren Bereichs der Leiterplatte gezeigt ist; in Fig. 3d die Verbindung des starren Bereichs der Leiterplatte mit dem flexiblen Bereich der Leiterplatte gezeigt ist; und in Fig. 3e die nach Herstellung der Verbindung zwischen dem starren Bereich und dem flexiblen Bereich der erfindungsgemäß hergestellten, starr-flexiblen Leiterplatte erfolgende Durchtrennung des starren Bereichs der Leiterplatte zur Ausbildung einer Biegestelle gezeigt ist.

In Fig. 1 ist eine schematische Darstellung eines starren Bereichs 1 einer in weiterer Folge herzustellenden, starr-flexiblen Leiterplatte gezeigt, wobei der starre Bereich 1 mehrlagig ausgebildet ist. Hiebei sind Kupferschichten 2 jeweils durch eine Prepregschicht 3 bzw. einen Kern 4 voneinander getrennt. Verbindungen zwischen einzelnen Kupferschichten 2 sind über Mikrovias 5 bzw. Durchtrittsöffnungen 6 angedeutet.

In Fig. 2 ist ein schematischer Schnitt durch einen flexiblen Bereich 7 einer herzustellenden, starr-flexiblen Leiterplatte angedeutet, wobei neben einer flexiblen Laminatschicht 8 eine Kupferschicht 9 als auch Lötmasken 10 bzw. 11 angedeutet sind. Für eine nachfolgend auszubildende Verbindung mit Teilbereichen des damit zu verbindenden, starren Bereichs 1 der Leiterplatte sind darüber hinaus Mikrovias bzw. Durchtrittsöffnungen 12 angedeutet.

In einem ersten Verfahrensschritt gemäß Fig. 3a wird auf dem wiederum mit 1 bezeichneten, starren Bereich der herzustellenden, starr-flexiblen Leiterplatte in einem Bereich einer nachfolgenden Durchtrennung derselben, wie dies insbesondere aus Fig. 3e ersichtlich ist, selektiv eine erste Kleberschicht 13 aufgebracht, welche in weiterer Folge vollständig gehärtet wird.

Nach dem Aufbringen und Härten der Kleberschicht 13 erfolgt in dem in Fig. 3b dargestellten Schritt eine Ausbildung von Fräskanten 14 im Bereich der nachfolgend herzustellenden Durchtrennung des starren Bereichs 1 der Leiterplatte, wobei die Fräskanten nicht nur die Kleberschicht 13, sondern auch daran angrenzende Lagen des starren Bereichs 1 der Leiterplatte durchdringen.

In einem weiteren Verfahrensschritt gemäß Fig. 3c wird anschließend an den Bereich der ersten Kleberschicht 13 eine zweite Kleberschicht 15 auf den starren Bereich 1 der Leiterplatte in im wesentlichen gleicher Schichtstärke wie die Kleberschicht 13 aufgebracht, wobei im Gegensatz zur vollständigen Härtung der Kleberschicht 13 die Kleberschicht 15 lediglich teilweise gehärtet wird.

Nachfolgend wird in dem in Fig. 3d dargestellten Verfahrensschritt der starre Bereich 1 der Leiterplatte mit dem flexiblen Bereich 7 der Leiterplatte unter Vermittlung der Kleberschicht 15 verbunden, wobei dies durch ein ebenfalls vollständiges Härten der Kleberschicht 15 vorgenommen wird.

Nach der Verbindung zwischen dem starren Bereich 1 der Leiterplatte sowie dem flexiblen Bereich 7 der Leiterplatte über die Verklebung durch die Kleberschichten 15 erfolgt im Bereich der vorab ausgebildeten Fräskanten 14 ausgehend von der von dem flexiblen Bereich 7 abgewandten Stirnfläche des starren Bereichs 1 eine Durchtrennung, wie sie mit 16 angedeutet ist, so daß nunmehr voneinander getrennte Teilbereiche 17 und 18 des ursprünglich einstückigen, starren Bereichs 1 der Leiterplatte über den flexiblen Bereich 7 verbunden sind.

Anschließend an die Verbindung zwischen den starren und nunmehr voneinander getrennten Teilbereichen 17 und 18 der Leiterplatte mit dem flexiblen Bereich 7 erfolgt nicht nur ein Vorsehen bzw. Ausbilden von Lötmasken 19 auf den starren Teilbereichen 17 und 18, sondern auch beispielsweise eine Durchkontaktierung zwischen der leitenden Kupferschicht 9 des flexiblen Bereichs 7 der herzustellenden, starr-flexiblen Leiterplatte und einer ersten Kupferschicht 2 der starren Teilbereiche 17 bzw. 18, wie dies bei 20 angedeutet ist.

Bei der in Fig. 3 dargestellten Verfahrensführung gelingt es, durch Vorsehen von zwei unterschiedlichen Kleberschichten 13 bzw. 15, im in Fig. 3e dargestellten Trennschritt eine einfache Durchtrennung insbesondere auch unter Berücksichtigung der vorab hergestellten Fräskanten 14 ohne Einhaltung übermäßig enger Toleranzen im Hinblick auf die Dicke der vorzusehenden Kleberschicht durchzuführen, da durch das Vorhärten der Kleberschicht 13 im Bereich der nachfolgenden Durchtrennung eine unmittelbare Anhaftung dieser an dem nachträglich festzulegenden, flexiblen Bereich 7 der Leiterplatte nicht vorliegt. Darüber hinaus ist aus der Darstellung gemäß Fig. 3b bis 3e ersichtlich, daß durch eine geringfügig größere Abmessung der ersten Kleberschicht 13 gegenüber der durch die Fräskanten 14 definierten Anordnung der Durchtrennung 16 ein Eindringen des Klebers bzw. der Kleberschicht 15 während der Verbindung mit dem flexiblen Bereich 7 der Leiterplatte verhindert wird.

In der in Fig. 3 erörterten Verfahrensweise findet beispielsweise für die Kleberschichten 13 und 15 jeweils ein identer Kleber Verwendung, wobei durch ein vorzeitiges, vollständiges Aushärten der Kleberschicht 13 eine nachträgliche Verbindung mit dem daran festzulegenden, flexiblen Bereich 7 der Leiterplatte vermieden wird.

Durch Einhaltung von Temperaturen unter 180 °C, insbesondere zwischen etwa 60 °C und 160 °C, für die Vorhärtung bzw. Vorvernetzung der zweiten Kleberschicht 15 wird darüber hinaus eine entsprechende Vorbereitung für die nachfolgende Verbindung mit dem flexiblen Bereich 7 zur Verfügung gestellt.

Anstelle einer Verwendung jeweils eines im wesentlichen identen Klebers für die Kleberschichten 13 und 15 und einer unterschiedlichen Vorbehandlung vor Festlegung des flexiblen Bereichs 7 der Leiterplatte kann naturgemäß auch ein Einsatz von unterschiedlichen Klebern für die Herstellung der Kleberschichten 13 und 15 vorgesehen sein, wobei für eine nachfolgende, einfache Ausbildung einer Durchtrennung 16 in dem starren Bereich 1 der Leiterplatte dafür gesorgt werden soll, daß wie bei dem in Fig. 3 dargestellten Ausführungsbeispiel ein schwächeres und günstigerweise vollständig fehlendes Anhaften an dem flexiblen Bereich 7 bei der nachfolgenden Festlegung zur einfacheren Entfernung des Klebers im Bereich der herzustellenden Durchtrennung 16 erzielbar ist.

Die Kleberschichten 13 und 15 können hiebei insbesondere abhängig von dem eingesetzten Klebermaterial beispielsweise durch einen Siebdruck, Schablonendruck, ein Streichbeschichten, Walzbeschichten oder Spinbeschichten in einer entsprechend gewünschten, geringen Dicke und mit der erforderlichen Genauigkeit für eine nachfolgende Registrierung bzw. Ausrichtung aufgebracht werden. Durch Einsatz derartiger, an sich bekannter Aufbringungsverfahren, insbesondere Drucktechniken, zur Ausbildung der Kleberschichten kann mit einer entsprechend geringen Schichtstärke, insbesondere weniger als 50 µm, besonders bevorzugt weniger als 40 µm, das Auslangen gefunden werden.

Darüber hinaus ist es durch Vorsehen einer Verklebung zwischen dem starren Bereich 1 bzw. 17 und 18 der Leiterplatte und dem flexiblen Bereich 7 der Leiterplatte möglich, beispielsweise gesetzlich vorgeschriebene Beschränkungen bei der Verwendung bestimmter, gefährlicher Stoffe in Elektro- und Elektronikgeräten in einfacher Weise zu berücksichtigen. Darüber hinaus ist es möglich, einen Kleber mit entsprechend geringem, thermischem Expansionskoeffizienten zu verwenden, wodurch sich die Verarbeitungsschritte weiter vereinfachen lassen.

Durch die Verwendung einer Verklebung zwischen den starren Teilbereichen 17 und 18 und dem flexiblen Bereich 7 der starr-flexiblen Leiterplatte wird insbesondere unter Berücksichtigung der erzielbaren, geringen Schichtstärke für die Verbindungsschicht und die daraus resultierende Verbesserung der Registriergenauigkeit möglich, Leiterplatten mit flexiblen Lagen für hochkomplexe Bauelemente auch in großen Formaten, beispielsweise im Produktionsformat von HDI-Leiterplatten von mehr als 18 x 24 Zoll, zur Verfügung zu stellen.

Durch eine Bereitstellung einer entsprechend geringen Schichtstärke durch Vorsehen der Kleberschicht, insbesondere von weniger als 40 µm, ist darüber hinaus eine aktive Flammhemmung nicht erforderlich.

Wie bereits mehrfach ausgeführt, kann mit einfachen Verfahren zur Aufbringung der Kleberschicht bzw. Kleberschichten das Auslangen gefunden werden, wobei derartige Kleberschichten auch entsprechend genau und hochpräzise aufgetragen werden können, so daß zusätzliche Bearbeitungsschritte, beispielsweise Stanzschritte zum Vorbereiten von entsprechenden blattartigen Folien gemäß dem Stand der Technik, entfallen können. Durch die Vereinfachung der Verfahrensführung, insbesondere durch Einsatz von druckfähigen Klebern und dadurch bedingt eine Vereinfachung des Verfahrens, ergeben sich darüber hinaus Möglichkeiten einer Zeit- und Kosteneinsparung bei einer Herstellung einer starr-flexiblen Leiterplatte.

Die in Fig. 1 dargestellte Ausführungsform einer mehrlagigen, starren Leiterplatte stellt nur zu Illustrationszwecken ein vereinfachtes Beispiel einer derartigen Leiterplatte dar, wobei selbstverständlich eine größere Anzahl bzw. Vielzahl von insbesondere leitenden Schichten 2 als auch Kontaktierung bzw. Mikrovias 5 entsprechend der gewünschten Komplexität des herzustellenden Bauteils Verwendung finden kann.

## Patentansprüche

1. Verfahren zum Herstellen einer starr-flexiblen Leiterplatte, wobei wenigstens ein starrer Bereich (1, 17, 18) einer Leiterplatte über eine Schicht aus nicht-leitendem Material bzw. eine Dielektrikumschicht (13, 15) mit wenigstens einem flexiblen Bereich (7) der Leiterplatte verbunden wird, wobei nach einem Verbinden des wenigstens einen starren und flexiblen Bereichs (7) der Leiterplatte der starre Bereich (1) der Leiterplatte durchtrennt wird und eine Verbindung zwischen den voneinander getrennten, starren Teilbereichen (17, 18) der Leiterplatte über den damit verbundenen, flexiblen Bereich (7) hergestellt wird, wobei die Verbindung zwischen dem wenigstens einen starren Bereich (1, 17, 18) der Leiterplatte und dem wenigstens einen flexiblen Bereich (7) der Leiterplatte vor einem Durchtrennen des starren Bereichs über eine Verklebung (13, 15) vorgenommen wird, wobei im Bereich der nachfolgenden Durchtrennung des starren Bereichs (1) der Leiterplatte eine Kleberschicht (13) aufgebracht wird, welche einer vollständigen Härtung unterworfen wird, **dadurch gekennzeichnet, dass** angrenzend an die partiell aufgebrachte und vollständig gehärtete Kleberschicht (13) eine weitere Kleberschicht (15) auf dem starren Bereich der Leiterplatte aufgebracht wird, welche in weiterer Folge lediglich teilweise gehärtet wird, dass nach dem teilweisen Härten der zweiten bzw. angrenzenden Kleberschicht (15) der starre Bereich der Leiterplatte mit dem flexiblen Bereich der Leiterplatte unter Zwischenschaltung der Kleberschicht durch ein anschließendes, vollständiges Härten der zweiten Kleberschicht (15) verbunden wird, und dass an der Stelle des nach Aufbringung des flexiblen Bereichs (7) der Leiterplatte zu durchtrennenden, starren Bereichs (1, 17, 18) der Leiterplatte und nach Aufbringen einer Kleberschicht (13) in an sich bekannter Weise Fräskanten (14) über einen Teilbereich der Dicke des starren Bereichs (1) der Leiterplatte ausgebildet werden.

2. Verfahren nach Anspruch 1, **dadurch gekennzeichnet, dass** nach einem Festlegen des flexiblen Bereichs (7) der Leiterplatte an dem starren Bereich (1) der Leiterplatte ausgehend von der von der Ausbildung der Fräskanten (14) abgewandten Oberfläche des starren Bereichs (1) der Leiterplatte eine Durchtrennung des starren Bereichs (1) der Leiterplatte bis in den Bereich der zwischen den Fräskanten (14) vorliegenden Kleberschicht (13) vorgenommen wird.

3. Verfahren nach Anspruch 1 oder 2, **dadurch gekennzeichnet, dass** die Verklebung zwischen dem starren und flexiblen Bereich (7, 17, 18) der Leiterplatte über einen druckfähigen Kleber (13, 15) vorgenommen wird.

4. Verfahren nach Anspruch 1, 2 oder 3, **dadurch gekennzeichnet, dass** die Schichtdicke der Verklebung (13, 15) mit weniger als 50 µm, insbesondere weniger als 40 µm, gewählt wird.

5. Verfahren nach einem der Ansprüche 1 bis 4, **dadurch gekennzeichnet, dass** ein Ein- oder Mehrkomponentenkleber (13, 15) verwendet wird, welcher thermisch vernetzend härtbar ist.

6. Verfahren nach Anspruch 5, **dadurch gekennzeichnet, dass** der Kleber (13, 15) basierend auf Epoxiden, Polyimiden, Phenolharzen oder Mischungen hievon, gegebenenfalls in Kombination mit Härtersystemen auf Basis von hydroxyl-, thiol- oder aminofunktionellen Vernetzungsgruppen gewählt wird.

7. Verfahren nach einem der Ansprüche 1 bis 6, **dadurch gekennzeichnet, dass** der Kleber (13, 15) mit anorganischen und/oder organischen Füllstoffen versehen wird.

8. Verfahren nach einem der Ansprüche 1 bis 7, **dadurch gekennzeichnet, dass** der Kleber (13, 15) durch Siebdruck, Schablonendruck, Streichbeschichten, Walzenbeschichten oder Spinbeschichten aufgebracht wird.

9. Verfahren nach einem der Ansprüche 1 bis 8, **dadurch gekennzeichnet, dass** der Kleber (13) selektiv im Bereich der nachfolgenden Durchtrennung des starren Bereichs (1) der Leiterplatte zur Ausbildung der getrennten, starren Teilbereiche (17, 18) aufgebracht wird.

10. Verfahren nach einem der Ansprüche 1 bis 9, **dadurch gekennzeichnet, dass** die Vorhärtung bzw. Vorvernetzung der zweiten Kleberschicht (15) bei Temperaturen unter 180 °C, insbesondere zwischen etwa 60 °C und 160 °C, vorgenommen wird.

11. Verfahren nach einem der Ansprüche 1 bis 10, **dadurch gekennzeichnet, dass** wenigstens für den starren Bereich (1, 17, 18) der Leiterplatte eine mehrlagige Leiterplatte verwendet wird.

## Claims

1. A method for producing a rigid-flexible circuit board, wherein at least one rigid portion or zone (1, 17, 18) of a printed circuit board is connected with at least one flexible portion or zone (7) of a printed circuit board via a layer of non-conductive material or dielectric layer (13, 15), wherein, after having connected the at least one rigid and flexible (7) portion of the circuit board, the rigid portion (1) of the circuit board is divided and a connection between the mutually separated rigid subportions or partial zones (17, 18) of the circuit board is produced via the flexible portion (7) connected therewith, wherein the connection between the at least one rigid portion (1, 17, 18) of the circuit board and the at least one flexible portion (7) of the circuit board is realized by an adhesion (13, 15) prior to dividing the rigid portion, wherein an adhesive layer (13) is applied in the region of the subsequent division of the rigid portion (1) of the circuit board, which adhesive layer is subjected to complete curing, **characterized in that** adjacent to the partially applied and completely cured adhesive layer (13), a further adhesive layer (15) is applied onto the rigid portion of the circuit board, which further adhesive layer is subsequently only partially cured, and that, after the partial curing of the second or adjacent adhesive layer (15), the rigid portion of the circuit board is connected with the flexible portion of the circuit board via the interposed adhesive layer by the subsequent complete curing of the second adhesive layer (15) and that on the site of the rigid portion (1, 17, 18) of the circuit board, which is to be divided upon application of the flexible portion (7) of the circuit board, and after having applied an adhesive layer (13), milling edges (14) are formed over a partial region of the thickness of the rigid portion (1) of the circuit board in a manner known per se.

2. A method according to claim 1, **characterized in that**, after having fixed the flexible portion (7) of the circuit board to the rigid portion (1) of the circuit board, a division of the rigid portion (1) of the circuit board is effected departing from the surface of the rigid portion (1) of the circuit board that faces away from the formation of the milling edges as far as into the region of the adhesive layer (13) provided between the milling edges (14).

3. A method according to claim 1 or 2, **characterized in that** the adhesion between the rigid and flexible portions (7, 17, 18) of the circuit board is made using a printable adhesive (13, 15).

4. A method according to claim 1, 2 or 3, **characterized in that** the layer thickness of the adhesion (13, 15) is chosen to be smaller than 50µm and, in particular, smaller than 40µm.

5. A method according to any one of claims 1 to 4, **characterized in that** a one- or multi-component thermosetting cross-linking adhesive (13, 15) is used.

6. A method according to claim 5, **characterized in that** the adhesive (13, 15) is selected on the basis of epoxides, polyimides, phenol resins or mixtures thereof, optionally in combination with curing systems based on hydroxyl-, thiol- or amino-functional cross-linking groups.

7. A method according to any one of claims 1 to 6, **characterized in that** the adhesive (13, 15) is provided with inorganic and/or organic fillers.

8. A method according to any one of claims 1 to 7, **characterized in that** the adhesive (13, 15) is applied by screen-printing, stencil-printing, spread-coating, roll-coating or spin-coating.

9. A method according to any one of claims 1 to 8, **characterized in that** the adhesive (13) is selectively applied in the region of the subsequent division of the rigid portion (1) of the circuit board for the formation of the separate rigid subportions (17, 18).

10. A method according to any of the claims 1 to 9, **characterized in that** the precuring and pre-cross-linking of the second adhesive layer (15) is carried out at temperatures of below 180°C and, in particular, between about 60°C and 160°C.

11. A method according to any one of claims 1 to 10, **characterized in that** a multilayer circuit board is at least used for the rigid portion (1, 17, 18) of the circuit board.

## Revendications

1. Procédé pour la fabrication d'une carte de circuits imprimés flexo-rigide, dans lequel au moins une zone rigide (1, 17, 18) d'une carte de circuits imprimés est reliée par une couche en un matériau non conducteur ou une couche diélectrique (13, 15) à au moins une zone flexible (7) de la carte de circuits imprimés, dans lequel, après une liaison de l'au moins une zone rigide et flexible (7) de la carte de circuits imprimés, la zone rigide (1) de la carte de circuits imprimés est séparée et une liaison est établie entre les zones partielles rigides (17, 18) de la carte de circuits imprimés séparées l'une de l'autre via la zone flexible (7) y étant reliée, dans lequel la liaison entre l'au moins une zone rigide (1, 17, 18) de la carte de circuits imprimés et l'au moins une zone flexible (7) de la carte de circuits imprimés est effectuée avant une séparation de la zone rigide via un collage (13, 15), dans lequel, dans la zone de séparation suivante de la zone rigide (1) de la carte de circuits imprimés, une couche d'adhésif (13) est appliquée, laquelle est soumise à un durcissement complet, **caractérisé en ce que**, de manière adjacente à la couche d'adhésif (13) partiellement appliquée et complètement durcie, on applique une autre couche d'adhésif (15) sur la zone rigide de la carte de circuits imprimés, laquelle est ensuite simplement partiellement durcie, **en ce qu'**après le durcissement partiel de la deuxième couche d'adhésif (15) ou couche d'adhésif adjacente, la zone rigide de la carte de circuits imprimés est reliée à la zone flexible de la carte de circuits imprimés via une interposition de la couche d'adhésif par un durcissement complet ultérieur de la deuxième couche d'adhésif (15), et **en ce qu'**à l'emplacement de la zone rigide (1, 17, 18) de la carte de circuits imprimés, à séparer après l'application de la zone flexible (7) de la carte de circuits imprimés et après l'application d'une couche d'adhésif (13), des bords de fraisage (14) sont réalisés d'une manière connue par ailleurs sur une zone partielle de l'épaisseur de la zone rigide (1) de la carte de circuits imprimés.

2. Procédé selon la revendication 1, **caractérisé en ce qu'**après une fixation de la zone flexible (7) de la carte de circuits imprimés à la zone rigide (1) de la carte de circuits imprimés, en partant de la surface de la zone rigide (1) de la carte de circuits imprimés tournant le dos à la formation des bords de fraisage (14), on procède à une séparation de la zone rigide (1) de la carte de circuits imprimés jusque dans la zone de couche d'adhésif (13) située entre les bords de fraisage (14).

3. Procédé selon la revendication 1 ou 2, **caractérisé en ce que** l'on procède au collage entre la zone rigide et flexible (7, 17, 18) de la carte de circuits imprimés via un adhésif de pression (13, 15).

4. Procédé selon la revendication 1, 2 ou 3, **caractérisé en ce que** l'épaisseur de couche du collage (13, 15) est choisie avec moins de 50 µm, en particulier moins de 40 µm.

5. Procédé selon l'une des revendications 1 à 4, **caractérisé en ce que** l'on utilise un adhésif à un seul composant ou à composants multiples (13, 15) durcissable par réticulation par voie thermique.

6. Procédé selon la revendication 5, **caractérisé en ce que** l'adhésif (13, 15) est sélectionné sur la base d'époxydes, de polyimides, de résines phénoliques ou de leurs mélanges, le cas échéant en combinaison avec des systèmes de durcissement sur la base de groupes de réticulation hydroxyles, thiol ou amino-fonctionnels.

7. Procédé selon l'une des revendications 1 à 6, **caractérisé en ce que** l'adhésif (13, 15) est doté de matières de remplissage inorganiques et/ou organiques.

8. Procédé selon l'une des revendications 1 à 7, **caractérisé en ce que** l'adhésif (13, 15) est appliqué par sérigraphie, impression au pochoir, revêtement par enduction, revêtement au rouleau ou revêtement par centrifugation.

9. Procédé selon l'une des revendications 1 à 8, **caractérisé en ce que** l'adhésif (13) est appliqué sélectivement dans la zone de la séparation suivante de la zone rigide (1) de la carte de circuits imprimés pour la formation des zones partielles rigides (17, 18) séparées.

10. Procédé selon l'une des revendications 1 à 9, **caractérisé en ce que** le durcissement préalable ou la réticulation préalable de la deuxième couche d'adhésif (15) s'effectue à des températures inférieures à 180 °C, en particulier comprises entre près de 60 °C et 160 °C.

11. Procédé selon l'une des revendications 1 à 10, **caractérisé en ce que** l'on utilise, au moins pour la zone rigide (1, 17, 18) de la carte de circuits imprimés, une carte de circuits imprimés multicouches.
